# EUROPEAN PATENT APPLICATION

(11) **EP 4 177 949 A1**
(43) Date of publication of application: **10.05.2023**
(21) Application number: 22205029.6
(22) Date of filing: 02.11.2022
(51) Int. Cl.: H01L 25/075, H01L 33/62, H01L 25/16

(54) **DISPLAY DEVICE**

(30) Priority: 04.11.2021 KR 20210150836
(71) Applicant: Samsung Display Co., Ltd., Yongin-si, Gyeonggi-do 17113 (KR)
(72) Inventor: LEE, Yong Hee, 17113 Yongin-si (KR); KWAK, Jin Seon, 17113 Yongin-si (KR); KIM, Kyung Bae, 17113 Yongin-si (KR); LEE, Ji Hye, 17113 Yongin-si (KR); PYO, Ki Hyun, 17113 Yongin-si (KR)
(74) Representative: Marks & Clerk LLP

(57) **Abstract**

A display device includes a first electrode and a second electrode on a substrate, a pixel unit including a light emitting element on the first electrode and the second electrode, a first signal line electrically connected to the first electrode, and a second signal line electrically connected to the second electrode, wherein first power is configured to be provided to the first electrode from the first signal line, wherein second power is configured to be provided to the second electrode from the second signal line, wherein at least a portion of the first signal line and at least a portion of the second signal line extend in a first direction, and wherein at least another portion of the first signal line extends in a second direction that is not parallel to the first direction.

## Description

### BACKGROUND

### 1. Field

The disclosure relates to a display device.

### 2. Description of the Related Art

In recent years, as interest in information display is increasing, research and development for a display device are continuously being conducted.

### SUMMARY

An aspect of the disclosure is to provide a display device in which heat generation in an area adjacent to an area to which power is supplied is reduced or prevented.

Another aspect of the disclosure is to provide a display device in which a likelihood of a short defect between electrode configurations is reduced or prevented.

Aspects of the disclosure are not limited to the above-described object, and other aspects which are not described will be clearly understood by those skilled in the art from the following description.

According to one or more embodiments of the disclosure, a display device may be provided. The display device may include a first electrode and a second electrode on a substrate, a pixel unit including a light emitting element on the first electrode and the second electrode, a first signal line electrically connected to the first electrode, and a second signal line electrically connected to the second electrode, wherein first power is configured to be provided to the first electrode from the first signal line, wherein second power is configured to be provided to the second electrode from the second signal line, wherein at least a portion of the first signal line and at least a portion of the second signal line extend in a first direction, and wherein at least another portion of the first signal line extends in a second direction that is not parallel to the first direction.

The display device may further include a display area in which the pixel unit is located, a non-display area surrounding at least a portion of the display area, a first power line having at least a portion in the non-display area, and configured to supply the first power to the first signal line, and a second power line having at least a portion in the non-display area, and configured to supply the second power to the second signal line, wherein the first power line and the second power line have a plate shape.

The first power line and the second power line may be spaced apart from each other in the first direction, and are on a same layer.

The first signal line may include a (1-1)-th signal line extending in the first direction, and a (1-2)-th signal line extending in the second direction, wherein the second signal line includes a (2-1)-th signal line extending in the first direction, and a (2-2)-th signal line extending in the second direction.

The pixel unit may include a first adjacent pixel area above the first power line in a plan view with respect to the second direction, and a second adjacent pixel area above the second power line in a plan view with respect to the second direction, wherein the first adjacent pixel area is not above the second power line with respect to the second direction, and the second adjacent pixel area is not above the second power line with respect to the second direction.

The (1-1)-th signal line and the (2-1)-th signal line may extend in a same direction in which the first power line and the second power line are spaced apart from each other.

The first power line may be electrically connected to the first electrode through the (1-1)-th signal line and the (1-2)-th signal line, wherein the second power line is electrically connected to the second electrode through the (2-1)-th signal line and the (2-2)-th signal line.

The first signal line may further include a (1-3)-th signal line electrically connected to the (1-2)-th signal line, and extending in a same direction as the (1-1)-th signal line, wherein the first power line is electrically connected to the first electrode through the (1-1)-th signal line, the (1-2)-th signal line, and the (1-3)-th signal line.

The first signal line may further include a (1-4)-th signal line including a first extension portion electrically connected to the (1-2)-th signal line, and extending in a same direction as the (1-1)-th signal line, and a second extension portion extending in a same direction as the (1-2)-th signal line, wherein the first power line is electrically connected to the first electrode through the (1-1)-th signal line, the (1-2)-th signal line, and the (1-4)-th signal line.

The display device may further include a third electrode on the substrate, and configured to be provided with the second power supplied from the second signal line, wherein the second electrode is on one side of the first electrode, and wherein the third electrode is on another side of the first electrode.

The first power line and the second power line may be on a layer that is different from that of the first electrode and the second electrode.

The first signal line and the second signal line may be on a layer that is different from that of the first electrode and the second electrode.

At least a portion of the first signal line may be on a layer that is different from that of at least a portion of the second signal line.

The display device may further include a transistor electrically connected to the light emitting element, and including a source electrode and a drain electrode, wherein the first signal line and the second signal line are on a same layer as the source electrode and the drain electrode.

A distance at which the first electrode and the second electrode are spaced apart from the substrate may be greater than a distance at which the first signal line and the second signal line are spaced apart from the substrate.

The display device may further include a display area in which the pixel unit is located, and a non-display area surrounding at least a portion of the display area, wherein an electrode configuration formed in a same process as that of the first electrode and the second electrode is not in the non-display area.

The first signal line and the second signal line may be on a same layer as the first power line and the second power line.

A distance at which the first signal line and the second signal line are spaced apart from the substrate may be less than a distance at which the first power line and the second power line are spaced apart from the substrate.

A thickness of the first electrode and a thickness of the second electrode may be greater than a thickness of the first signal line and a thickness of the second signal line.

According to one or more other embodiments of the disclosure, a display device includes a display area and a non-display area, a first alignment electrode and a second alignment electrode on the display area, a pixel unit including a light emitting element having at least a portion positioned between the first alignment electrode and the second alignment electrode, a driving controller in the non-display area and configured to control driving of the pixel unit, and a line unit including a first signal line electrically connected to the first alignment electrode, and a second signal line electrically connected to the second alignment electrode, wherein the non-display area includes a fan-out area positioned between the display area and the driving controller, wherein the line unit includes a first power line and a second power line having at least a portion in the fan-out area, and spaced apart from each other in a first direction, the first power line being configured to supply first power to the light emitting element through the first signal line and the first alignment electrode, wherein the second power line is configured to supply second power different from the first power to the light emitting element through the second signal line and the second alignment electrode, and wherein at least a portion of each of the first signal line and the second signal line extends in the first direction.

Aspects of the disclosure are not limited to the above, and other aspects that are not described will be clearly understood by those skilled in the art from the present specification and the accompanying drawings.

According to one or more embodiments of the disclosure, a display device with reduced heat generation with respect to an area to which power is supplied, and improved performance and user reliability, may be provided.

According to one or more other embodiments of the disclosure, a display device, in which a likelihood of a short defect between electrode configurations is reduced or prevented, and thus, reliability of an electrical signal is improved, may be provided.

At least some of the above and other features of the invention are set out in the claims.

The disclosure is not limited to the above-described aspects, and aspects that are not described will be clearly understood by those skilled in the art from the present specification and the accompanying drawings.

### BRIEF DESCRIPTION OF THE DRAWINGS

The above and other aspects of the disclosure will become more apparent by describing in further detail embodiments thereof with reference to the accompanying drawings, in which:
FIGS. 1 and 2 are perspective and cross-sectional views illustrating a light emitting element according to one or more embodiments;
FIG. 3 is a block diagram illustrating a display device according to one or more embodiments;
FIG. 4 is a plan view illustrating a display device according to one or more embodiments;
FIG. 5 is a circuit diagram illustrating a pixel circuit included in a pixel according to one or more embodiments;
FIG. 6 is a diagram illustrating a stack structure included in a display device according to one or more embodiments;
FIG. 7 is an enlarged view of an area EA1 of FIG. 4;
FIG. 8 is an enlarged view of an area EA2 of FIG. 4;
FIG. 9 is an enlarged view of the area EA2 of FIG. 4, and is a plan view illustrating an electrode structure according to one or more embodiments;
FIG. 10 is an enlarged view of an area EA3 of FIG. 9;
FIGS. 11 and 12 are layout diagrams illustrating electrode configurations configuring a pixel according to one or more embodiments;
FIGS. 13 and 14 are plan views schematically illustrating an electrode line according to one or more embodiments; and
FIG. 15 is a cross-sectional view taken along a line I ~ I' of FIG. 13.

### DETAILED DESCRIPTION

Aspects of some embodiments of the present disclosure and methods of accomplishing the same may be understood more readily by reference to the detailed description of embodiments and the accompanying drawings. Hereinafter, embodiments will be described in more detail with reference to the accompanying drawings.

Because the embodiments described in the present specification are for clearly describing the present disclosure to those skilled in the art to which the present disclosure pertains, the disclosure is not limited by the embodiments described in the present specification, and the scope of the present disclosure should be interpreted as including modifications or variations that do not depart from of the present disclosure. The described embodiments may have various modifications and may be embodied in various different forms, and should not be construed as being limited to only the illustrated embodiments herein. Rather, these embodiments are provided as examples so that this disclosure will be thorough and complete, and will fully convey the aspects of the present disclosure to those skilled in the art, and it should be understood that the present disclosure covers all the modifications, equivalents, and replacements within the idea and technical scope of the present disclosure. Accordingly, processes, elements, and techniques that are not necessary to those having ordinary skill in the art for a complete understanding of the aspects of the present disclosure may not be described.

Unless otherwise noted, like reference numerals, characters, or combinations thereof denote like elements throughout the attached drawings and the written description, and thus, descriptions thereof will not be repeated. Further, parts that are not related to, or that are irrelevant to, the description of the embodiments might not be shown to make the description clear.

In the drawings, the relative sizes of elements, layers, and regions may be exaggerated for clarity. Additionally, the use of cross-hatching and/or shading in the accompanying drawings is generally provided to clarify boundaries between adjacent elements. As such, neither the presence nor the absence of cross-hatching or shading conveys or indicates any preference or requirement for particular materials, material properties, dimensions, proportions, commonalities between illustrated elements, and/or any other characteristic, attribute, property, etc., of the elements, unless specified.

Various embodiments are described herein with reference to sectional illustrations that are schematic illustrations of embodiments and/or intermediate structures. As such, variations from the shapes of the illustrations as a result, for example, of manufacturing techniques and/or tolerances, are to be expected. Further, specific structural or functional descriptions disclosed herein are merely illustrative for the purpose of describing embodiments according to the concept of the present disclosure. Thus, embodiments disclosed herein should not be construed as limited to the particular illustrated shapes of regions, but are to include deviations in shapes that result from, for instance, manufacturing.

For example, an implanted region illustrated as a rectangle will, typically, have rounded or curved features and/or a gradient of implant concentration at its edges rather than a binary change from implanted to non-implanted region. Likewise, a buried region formed by implantation may result in some implantation in the region between the buried region and the surface through which the implantation takes place.

Thus, the regions illustrated in the drawings are schematic in nature and their shapes are not intended to illustrate the actual shape of a region of a device and are not intended to be limiting. Additionally, as those skilled in the art would realize, the described embodiments may be modified in various different ways, all without departing from the scope of the present disclosure.

In the detailed description, for the purposes of explanation, numerous specific details are set forth to provide a thorough understanding of various embodiments. It is apparent, however, that various embodiments may be practiced without these specific details or with one or more equivalent arrangements. In other instances, well-known structures and devices are shown in block diagram form in order to avoid unnecessarily obscuring various embodiments.

Spatially relative terms, such as "beneath," "below," "lower," "under," "above," "upper," and the like, may be used herein for ease of explanation to describe one element or feature's relationship to another element(s) or feature(s) as illustrated in the figures. It will be understood that the spatially relative terms are intended to encompass different orientations of the device in use or in operation, in addition to the orientation depicted in the figures. For example, if the device in the figures is turned over, elements described as "below" or "beneath" or "under" other elements or features would then be oriented "above" the other elements or features. Thus, the example terms "below" and "under" can encompass both an orientation of above and below. The device may be otherwise oriented (e.g., rotated 90 degrees or at other orientations) and the spatially relative descriptors used herein should be interpreted accordingly. Similarly, when a first part is described as being arranged "on" a second part, this indicates that the first part is arranged at an upper side or a lower side of the second part without the limitation to the upper side thereof on the basis of the gravity direction.

Further, in this specification, the phrase "on a plane," or "plan view," means viewing a target portion from the top, and the phrase "on a cross-section" means viewing a cross-section formed by vertically cutting a target portion from the side.

It will be understood that when an element, layer, region, or component is referred to as being "formed on," "on," "connected to," or "coupled to" another element, layer, region, or component, it can be directly formed on, on, connected to, or coupled to the other element, layer, region, or component, or indirectly formed on, on, connected to, or coupled to the other element, layer, region, or component such that one or more intervening elements, layers, regions, or components may be present. In addition, this may collectively mean a direct or indirect coupling or connection and an integral or non-integral coupling or connection. For example, when a layer, region, or component is referred to as being "electrically connected" or "electrically coupled" to another layer, region, or component, it can be directly electrically connected or coupled to the other layer, region, and/or component or intervening layers, regions, or components may be present. However, "directly connected/directly coupled," or "directly on," refers to one component directly connecting or coupling another component, or being on another component, without an intermediate component. Meanwhile, other expressions describing relationships between components such as "between," "immediately between" or "adjacent to" and "directly adjacent to" may be construed similarly. In addition, it will also be understood that when an element or layer is referred to as being "between" two elements or layers, it can be the only element or layer between the two elements or layers, or one or more intervening elements or layers may also be present.

For the purposes of this disclosure, expressions such as "at least one of," when preceding a list of elements, modify the entire list of elements and do not modify the individual elements of the list. For example, "at least one of X, Y, and Z," "at least one of X, Y, or Z," and "at least one selected from the group consisting of X, Y, and Z" may be construed as X only, Y only, Z only, any combination of two or more of X, Y, and Z, such as, for instance, XYZ, XYY, YZ, and ZZ, or any variation thereof. Similarly, the expression such as "at least one of A and B" may include A, B, or A and B. As used herein, "or" generally means "and/or," and the term "and/or" includes any and all combinations of one or more of the associated listed items. For example, the expression such as "A and/or B" may include A, B, or A and B.

It will be understood that, although the terms "first," "second," "third," etc., may be used herein to describe various elements, components, regions, layers and/or sections, these elements, components, regions, layers and/or sections should not be limited by these terms. These terms are used to distinguish one element, component, region, layer or section from another element, component, region, layer or section. Thus, a first element, component, region, layer or section described below could be termed a second element, component, region, layer or section, without departing from the scope of the present disclosure. The description of an element as a "first" element may not require or imply the presence of a second element or other elements. The terms "first", "second", etc. may also be used herein to differentiate different categories or sets of elements. For conciseness, the terms "first", "second", etc. may represent "first-category (or first-set)", "second-category (or second-set)", etc., respectively.

In the examples, the x-axis, the y-axis, and/or the z-axis are not limited to three axes of a rectangular coordinate system, and may be interpreted in a broader sense. For example, the x-axis, the y-axis, and the z-axis may be perpendicular to one another, or may represent different directions that are not perpendicular to one another. The same applies for first, second, and/or third directions.

The terminology used herein is for the purpose of describing particular embodiments only and is not intended to be limiting of the present disclosure. As used herein, the singular forms "a" and "an" are intended to include the plural forms as well, unless the context clearly indicates otherwise. It will be further understood that the terms "comprises," "comprising," "have," "having," "includes," and "including," when used in this specification, specify the presence of the stated features, integers, steps, operations, elements, and/or components, but do not preclude the presence or addition of one or more other features, integers, steps, operations, elements, components, and/or groups thereof.

When one or more embodiments may be implemented differently, a specific process order may be performed differently from the described order. For example, two consecutively described processes may be performed substantially at the same time or performed in an order opposite to the described order.

As used herein, the term "substantially," "about," "approximately," and similar terms are used as terms of approximation and not as terms of degree, and are intended to account for the inherent deviations in measured or calculated values that would be recognized by those of ordinary skill in the art. "About" or "approximately," as used herein, is inclusive of the stated value and means within an acceptable range of deviation for the particular value as determined by one of ordinary skill in the art, considering the measurement in question and the error associated with measurement of the particular quantity (i.e., the limitations of the measurement system). For example, "about" may mean within one or more standard deviations, or within ± 30%, 20%, 10%, 5% of the stated value. Further, the use of "may" when describing embodiments of the present disclosure refers to "one or more embodiments of the present disclosure."

Unless otherwise defined, all terms (including technical and scientific terms) used herein have the same meaning as commonly understood by one of ordinary skill in the art to which the present disclosure belongs. It will be further understood that terms, such as those defined in commonly used dictionaries, should be interpreted as having a meaning that is consistent with their meaning in the context of the relevant art and/or the present specification, and should not be interpreted in an idealized or overly formal sense, unless expressly so defined herein.

A term used in the present specification may be selected as a general term that is currently widely used in consideration of a function of the present disclosure, the terms may vary according to the intention of those skilled in the art to which the present disclosure pertains, customs, the appearance of new technologies, or the like. However, unlike this, when a specific term is defined as an arbitrary meaning and used, the meaning of the term will be described separately. Therefore, the terms used in the present specification should be interpreted based on the actual meaning thereof and contents throughout the present specification, other than a name of a simple term.

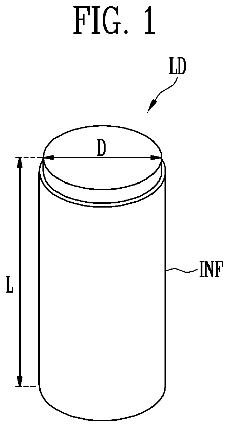

The disclosure relates to a display device. Hereinafter, a display device according to one or more embodiments is described with reference to FIGS. 1 to 15.

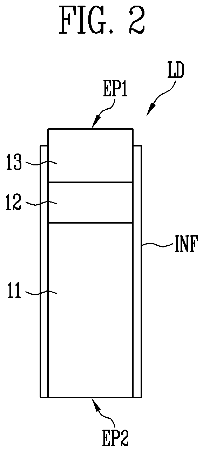

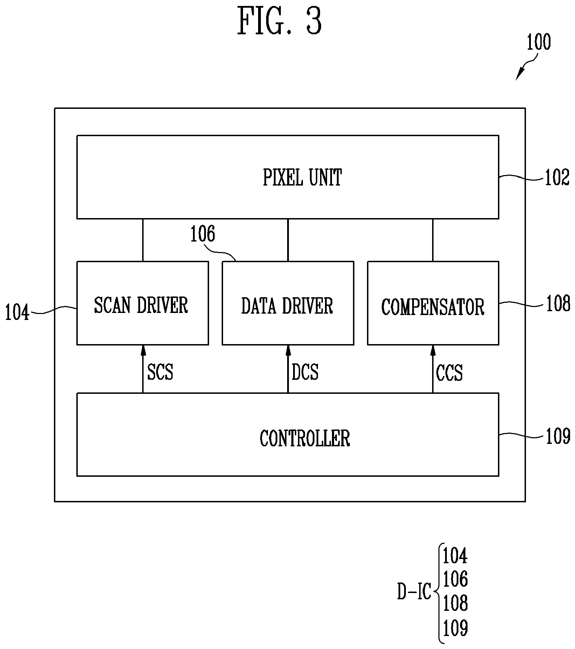

FIGS. 1 and 2 show a light emitting element LD included in a display device (refer to reference character 100 of FIG. 3) according to one or more embodiments. FIGS. 1 and 2 are perspective and cross-sectional views illustrating a light emitting element according to one or more embodiments. Although FIGS. 1 and 2 shows a columnar light emitting element LD, a type and/or a shape of the light emitting element LD are/is not limited thereto.

Referring to FIGS. 1 and 2, the light emitting element LD may include a first semiconductor layer 11, a second semiconductor layer 13, and an active layer 12 interposed between the first and second semiconductor layers 11 and 13. As an example, when an extension direction of the light emitting element LD is a length L direction, the light emitting element LD may include the first semiconductor layer 11, the active layer 12, and the second semiconductor layer 13 sequentially stacked along the length L direction.

The light emitting element LD may be provided in a column shape extending along one direction. The light emitting element LD may have a first end EP1 and a second end EP2. One of the first and second semiconductor layers 11 and 13 may be adjacent to the first end EP1 of the light emitting element LD. The remaining one of the first and second semiconductor layers 11 and 13 may be adjacent to the second end EP2 of the light emitting element LD.

According to one or more embodiments, the light emitting element LD may be a light emitting element manufactured in a column shape through an etching method or the like. In the present specification, the term "column shape" encompasses a rod-like shape or a bar-like shape that is long in the length L direction (that is, an aspect ratio is greater than 1), such as a circular column or a polygonal column, and a shape of a cross section thereof is not particularly limited. For example, a length L of the light emitting element LD may be greater than a diameter D (or a width of the cross section) thereof.

According to one or more embodiments, the light emitting element LD may have a size as small as a nano scale to a micro scale (nanometer scale to micrometer scale). As an example, each of the light emitting elements LD may have a D diameter (or width) and/or a length L of a nano scale to micro scale range. However, the size of the light emitting element LD is not limited thereto.

The first semiconductor layer 11 may be a first conductivity type semiconductor layer. For example, the first semiconductor layer 11 may include an N-type semiconductor layer. As an example, the first semiconductor layer 11 may include any one semiconductor material among InAIGaN, GaN, AIGaN, InGaN, AIN, and InN, and may include an N-type semiconductor layer doped with a first conductivity type dopant such as Si, Ge, and Sn. However, the material configuring the first semiconductor layer 11 is not limited thereto.

The active layer 12 may be located on the first semiconductor layer 11, and may be formed in a single-quantum well or multi-quantum well structure. A position of the active layer 12 may be variously changed according to a type of the light emitting element LD.

In some embodiments, a clad layer doped with a conductive dopant may be formed on and/or under the active layer 12. For example, the clad layer may be formed as an AIGaN layer or an InAIGaN layer. According to one or more embodiments, a material of AIGaN, InAIGaN, or the like may be used to form the active layer 12, and various other materials may configure the active layer 12

The second semiconductor layer 13 may be located on the active layer 12 and may include a semiconductor layer of a type different from that of the first semiconductor layer 11. For example, the second semiconductor layer 13 may include a P-type semiconductor layer. As an example, the second semiconductor layer 13 may include at least one semiconductor material among InAIGaN, GaN, AIGaN, InGaN, AIN, and InN, and may include a P-type semiconductor layer doped with a second conductivity type dopant such as Mg. However, the material configuring the second semiconductor layer 13 is not limited thereto, and various other materials may configure the second semiconductor layer 13.

When a voltage greater than or equal to a threshold voltage is applied to both ends of the light emitting element LD, electron-hole pairs are combined in the active layer 12, and thus the light emitting element LD emits light. By controlling the light emission of the light emitting element LD using this principle, the light emitting element LD may be used as a light source of various light emitting devices including a pixel of a display device.

According to one or more embodiments, the light emitting element LD may further include an insulating layer INF provided on a surface. The insulating layer INF may be formed of a single layer or a double layer, but is not limited thereto, and may be formed of a plurality of layers. As an example, the insulating layer INF may include a first insulating layer including a first material and a second insulating layer including a second material different from the first material.

According to one or more embodiments, the insulating layer INF may expose both ends of the light emitting element LD having different polarities. For example, the insulating layer INF may expose one end of each of the first and second semiconductor layers 11 and 13 positioned at the first and second ends EP1 and EP2 of the light emitting element LD.

According to one or more embodiments, the insulating layer INF may be configured of a single layer or a multilayer by including at least one insulating material among silicon oxide (SiOx), silicon nitride (SiNx), silicon oxynitride (SiOxNy), aluminum oxide (AlOx), and titanium oxide (TiOx), but is not limited thereto.

According to one or more embodiments, the insulating layer INF may secure electrical stability of the light emitting element LD. In addition, even though a plurality of light emitting elements LD are located closely with each other, the likelihood of an unwanted short circuit may be reduced or prevented from occurring between the light emitting elements LD.

According to one or more embodiments, the light emitting element LD may further include an additional configuration in addition to the first semiconductor layer 11, the active layer 12, the second semiconductor layer 13, and/or the insulating layer INF surrounding the first semiconductor layer 11, the active layer 12, and the second semiconductor layer 13. For example, the light emitting element LD may additionally include at least one phosphor layer, active layer, semiconductor layer, and/or electrode layer located on one end side of the first semiconductor layer 11, the active layer 12, and/or the second semiconductor layer 13. As one or more embodiments, a contact electrode layer may be further located on each of the first and second ends EP1 and EP2 of the light emitting element LD.

FIG. 3 is a block diagram illustrating a display device according to one or more embodiments.

The display device 100 refers to a device configured to provide visual data to a user. The display device 100 may be an electronic device using the light emitting element LD described above with reference to FIGS. 1 and 2 as a light source. According to an example, the display device 100 may be a tablet PC, a television, a smart phone, or a notebook computer, but is not limited to a specific example.

According to one or more embodiments, the display device 100 may include a pixel unit 102 and a driving controller D-IC. According to an example, the driving controller D-IC may include a scan driver 104, a data driver 106, a compensator 108, and a controller 109.

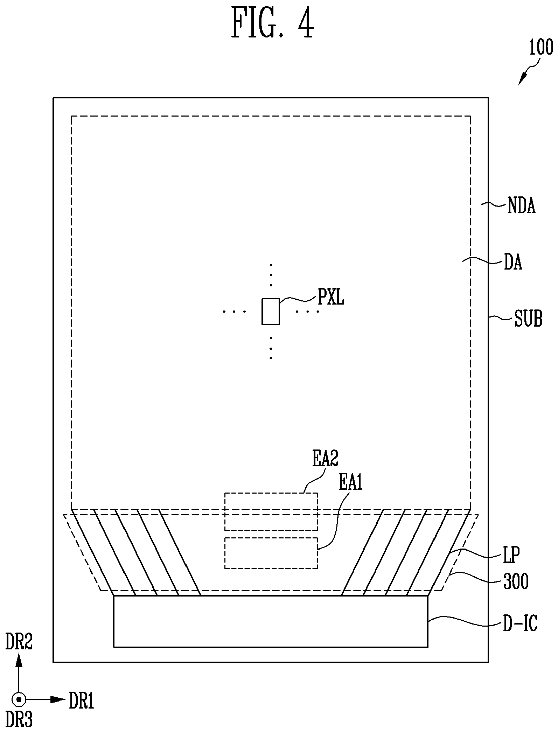

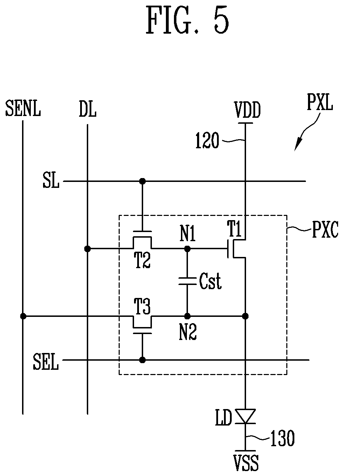

The pixel unit 102 may include a pixel (refer to reference character PXL of FIG. 4) connected to a scan line (refer to reference character SL of FIG. 5) and a data line (refer to reference character DL of FIG. 5). According to one or more embodiments, the pixel PXL may include a plurality of sub-pixels. For example, each of the plurality of sub-pixels may emit light having different colors.

The scan driver 104 may be connected to the pixel unit 102. The scan driver 104 may be located on one side of the pixel unit 102. The scan driver 104 may receive a first control signal SCS from the controller 109. The scan driver 104 may supply a scan signal to the scan lines SL in response to the first control signal SCS.

According to one or more embodiments, the first control signal SCS may be a signal for controlling a driving timing of the scan driver 104. The first control signal SCS may include a scan start signal and a plurality of clock signals for the scan signal. The scan signal may be set to a gate-on level corresponding to a type of a transistor to which a corresponding scan signal is supplied.

The data driver 106 may be connected to the pixel unit 102. The data driver 106 may be located on one side of the pixel unit 102. The data driver 106 may receive a second control signal DCS from the controller 109. The data driver 106 may supply a data signal to the data line DL in response to the second control signal DCS.

According to one or more embodiments, the second control signal DCS may be a signal for controlling a driving timing of the data driver 106.

The compensator 108 may be connected to the pixel unit 102. The compensator 108 may receive a sensing value (current or voltage information) extracted from the pixel PXL through a sensing line (refer to reference character SENL of FIG. 5). The compensator 108 may generate a compensation value for compensating for deterioration of the pixel PXL based on the sensing value. For example, the compensator 108 may obtain information on a characteristic change of a first transistor (refer to reference character T1 of FIG. 5) and/or the light emitting element LD (for example, a threshold voltage change of the first transistor T1, a mobility change, and other characteristic changes). The compensator 108 may calculate the compensation value for compensating for the data signal based on the information on the characteristic change, and may provide the compensation value to the controller 109 or the data driver 106.

According to one or more embodiments, the compensator 108 may receive a third control signal CCS from the controller 109. The compensator 108 may supply the sensing signal to the pixel PXL in response to the third control signal CCS.

According to one or more embodiments, the third control signal CCS may be a signal for controlling driving of the compensator 108 for sensing and compensating for the deterioration of the pixels PXL.

The controller 109 may obtain the first control signal SCS, the second control signal DCS, and the third control signal CCS. The controller 109 may generate the first control signal SCS and the second control signal DCS, and may provide the first control signal SCS and the second control signal DCS to the scan driver 104 and the data driver 106, respectively. The controller 109 may generate the third control signal CCS, and may provide the third control signal CCS to the compensator 108.

According to one or more embodiments, a single side driving structure in which the scan driver 104 and the data driver 106 are located on one side of the pixel unit 102 may be provided.

Hereinafter, for convenience of description, the disclosure is described based on the display device 100 including the single side driving structure.

In FIG. 3, the scan driver 104, the data driver 106, the compensator 108, and the controller 109 are separately shown, but at least a portion of the scan driver 104, the data driver 106, the compensator 108, and the controller 109 may be integrated into one module or integrated circuit chip (IC). For example, a configuration and/or a function of at least a portion of the controller 109 may be included in the data driver 106.

FIG. 4 is a plan view illustrating a display device according to one or more embodiments.

Referring to FIG. 4, the display device 100 may include a substrate SUB and the pixel PXL including the light emitting element LD. According to one or more embodiments, the display device 100 may include a display area DA and a non-display area NDA. The display device 100 may include the driving controller D-IC and a line unit LP.

The substrate SUB may configure a base member of the display device 100. According to an example, the substrate SUB may be a rigid or flexible substrate or film, but is not limited to any specific example.

The pixel PXL may be located in the display area DA. Light may be emitted from the display area DA. The non-display area NDA may mean an area in which the pixel PXL is not located. The non-display area NDA may mean an area excluding the display area DA. For example, the non-display area NDA may be provided to surround at least a portion of the display area DA when viewed in a plan view.

According to one or more embodiments, the driving controller D-IC may be located in the non-display area NDA. In addition, at least a portion of the line unit LP may be located in the non-display area NDA. In some embodiments, a pad portion electrically connecting the driving controller D-IC and the line unit LP may be further located in the non-display area NDA.

The pixel PXL may be located in the display area DA. The pixel PXL may be regularly arranged according to a stripe or PENTlLE^{™} arrangement structure, which may be may be referred to as an RGBG matrix structure (e.g., a PENTlLE^{™} matrix structure, a PENTILE^{™} structure, or an RGBG structure, PENTILE^{™} being a registered trademark of Samsung Display Co., Ltd., Republic of Korea). However, an arrangement structure of the pixel PXL is not limited thereto.

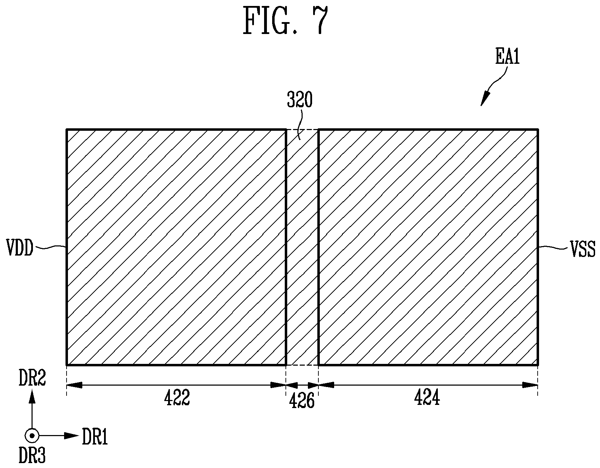

According to one or more embodiments, the pixel PXL may be connected to the driving controller D-IC through the line unit LP. The line unit LP may include a fan-out line (refer to reference character 320 of FIG. 7), a first power line (refer to reference character VDD of FIG. 7), and a second power line (refer to reference character VSS of FIG. 7). The fan-out line 320 may include the scan line SL, the data line DL, and the sensing line SENL.

The driving controller D-IC may provide a signal (e.g., predetermined signal) and power (e.g., predetermined power) to the pixel PXL. The pixel PXL may be driven based on the signal (e.g., predetermined signal) and the power (e.g., predetermined power). The signal and the power applied from the driving controller D-IC may be applied to the pixel PXL via the line unit LP. According to one or more embodiments, the pixel PXL may be driven based on an electrical signal provided from the scan line SL, the data line DL, the sensing line SENL, the first power line VDD, and the second power line VSS.

The line unit LP may be located in the non-display area NDA. The line unit LP may surround at least a portion of the display area DA. According to an example, at least a portion of the line unit LP may be located between the display area DA and the driving controller D-IC. Although the line unit LP is located only between the display area DA and the driving controller D-IC in FIG. 4, the disclosure is not limited thereto. According to one or more embodiments, the line unit LP may be located at a position adjacent to the display area DA.

According to one or more embodiments, the line unit LP may electrically connect the driving controller D-IC and the pixel PXL. According to an example, the line unit LP may include at least a portion of each of the scan line SL, the data line DL, the first power line VDD, and/or the second power line VSS.

According to one or more embodiments, the line unit LP may include a fan-out area 300. The line unit LP may include the fan-out line 320 located in the fan-out area 300. The fan-out area 300 may be located between the display area DA and the driving controller D-IC when viewed in a plan view.

According to an example, when viewed in a plan view, the fan-out line 320 may include at least a portion of each of the scan line SL, the data line DL, and the sensing line SENL as lines located in the fan-out area 300.

According to one or more embodiments, at least a portion of each of the first power line VDD and the second power line VSS may be located in the non-display area NDA. At least a portion of each of the first power line VDD and the second power line VSS may be located in the fan-out area 300.

According to one or more embodiments, the fan-out area 300 may have a shape that becomes wider toward one direction. The fan-out area 300 may have different widths along the second direction DR2. For example, a width of the fan-out area 300 may increase from the driving controller D-IC toward the display area DA.

FIG. 5 is a circuit diagram illustrating a pixel circuit included in a pixel according to one or more embodiments. FIG. 5 shows the pixel PXL described above with reference to FIG. 4.

Referring to FIG. 5, the sub pixel SPXL may include the light emitting element LD and the pixel circuit PXC.

The light emitting element LD may be connected between the first power line VDD and the second power line VSS. One end (for example, a P-type semiconductor) of the light emitting element LD may be connected to the first power line VDD via the pixel circuit PXC and a first signal line 120, and another end (for example, an N-type semiconductor) of the light emitting element LD may be connected to the second power line VSS via a second signal line 130.

According to one or more embodiments, when a driving current is supplied through the pixel circuit PXC, the light emitting element LD may emit light of a luminance corresponding to the driving current.

According to one or more embodiments, the light emitting elements LD may be connected to each other through various connection structures between the first power line VDD and the second power line VSS. For example, the light emitting elements LD may be connected to each other only in parallel or may be connected to each other only in series. Alternatively, the light emitting elements LD may be connected in a series/parallel mixed structure.

The first power line VDD and the second power line VSS may have different potentials so that the light emitting elements LD may emit light. For example, the first power line VDD may be set to a potential higher than that of the second power line VSS.

According to one or more embodiments, the first power line VDD and the second power line VSS may have a potential difference of a level at which light may be emitted during an emission period of the pixel PXL.

The pixel circuit PXC may connect between the first power line VDD and the light emitting element LD. The pixel circuit PXC may include a first transistor T1, a second transistor T2, a third transistor T3, and a storage capacitor Cst.

One electrode of the first transistor T1 may be connected to the first power line VDD, and another electrode may be connected to one electrode (for example, an anode electrode) of the light emitting element LD. A gate electrode of the first transistor T1 may be connected to a first node N1. The first transistor T1 may control a current flowing through the light emitting element LD in response to a voltage applied through the first node N1.

One electrode of the second transistor T2 may be connected to the data line DL, and another electrode may be connected to the first node N1. A gate electrode of the second transistor T2 may be connected to the scan line SL. When the scan signal is supplied from the scan line SL, the second transistor T2 may be turned on, and at this time, the second transistor T2 may transfer the data signal provided from the data line DL to the first node N1.

One electrode of the third transistor T3 may be connected to the sensing line SENL, and another electrode may be connected to a second node N2. A gate electrode of the third transistor T3 may be connected to a sensing signal line SEL. When the third transistor T3 is turned on in response to a sensing signal provided from the sensing signal line SEL, a reference voltage may be provided to the second node N2 through the sensing line SENL.

According to one or more embodiments, the reference voltage may set or initialize a voltage of an electrode of the first transistor T1 connected to the light emitting element LD (for example, a source electrode of the first transistor T1) to a constant value. According to an example, the reference voltage may be set to be less than or equal to a voltage of the second power line VSS.

According to one or more embodiments, when the third transistor T3 is turned on in response to the sensing signal provided from the sensing signal line SEL, the third transistor T3 may transfer a sensing current to the sensing line SENL.

According to one or more embodiments, he sensing current may be provided to the compensator 108. The sensing current may be used to calculate a change amount of mobility and a threshold voltage of the first transistor T1.

The storage capacitor Cst may be connected between the first node N1 (or the gate electrode of the first transistor T1) and the second node N2 (or another electrode of the first transistor T1). The storage capacitor Cst may store information on a difference between a voltage of the first node N1 and a voltage of the second node N2.

Meanwhile, a structure of the pixel circuit PXC is not limited to the structure shown in FIG. 5, and various types of structures may be implemented. In addition, in FIG. 5, the first to third transistors T1 to T3 are shown based on N-type transistors, but the disclosure is not limited thereto, and the first to third transistors T1 to T3 may be configured of P type transistors according to one or more embodiments.

Hereinafter, electrode lines of the display device 100 according to one or more embodiments are described. However, before describing the electrode lines of the display device 100, a stack structure defined in the display device 100 according to one or more embodiments is described first.

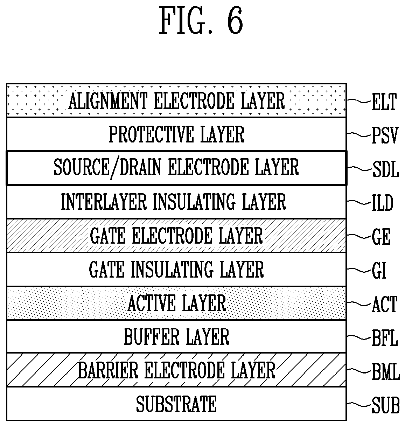

FIG. 6 is a diagram illustrating a stack structure included in a display device according to one or more embodiments. Referring to FIG. 6, the stack structure included in the display device according to one or more embodiments may have a shape in which at least a portion is patterned in a structure in which the substrate SUB, a barrier electrode layer BML, a buffer layer BFL, an active layer ACT, a gate insulating layer GI, a gate electrode layer GE, an interlayer insulating layer ILD, a source/drain electrode layer SDL, a protective layer PSV, and an alignment electrode layer ELT are sequentially stacked.

The substrate SUB configures the base member of the display device 100, and may refer to a rigid or flexible substrate or film.

The buffer layer BFL may refer to a layer for reducing or preventing impurities from diffusing or moisture permeation into the active layer ACT including a semiconductor. According to one or more embodiments, the buffer layer BFL may include at least one of metal oxide such as silicon nitride (SiNx), silicon oxide (SiOx), silicon oxynitride (SiOxNy), and aluminum oxide (AlOx).

The active layer ACT may be a layer including a semiconductor. For example, the active layer ACT may include at least one of polysilicon, amorphous silicon, and an oxide semiconductor. According to one or more embodiments, the active layer ACT may configure a channel of the first to third transistors T1 to T3, and an impurity may be doped in a portion that is in contact with the source/drain electrode layer SDL.

The barrier electrode layer BML, the gate electrode layer GE, the source/drain electrode layer SDL, and the alignment electrode layer ELT may be layers including one or more conductors. Each of the barrier electrode layer BML, the gate electrode layer GE, and the source/drain electrode layer SDL may be configured as a single layer or a multilayer. According to one or more embodiments, each of the barrier electrode layer BML, the gate electrode layer GE, and the source/drain electrode layer SDL may include at least one of gold (Au), silver (Ag), aluminum (Al), molybdenum (Mo), chromium (Cr), titanium (Ti), nickel (Ni), neodymium (Nd), copper (Cu), and platinum (Pt). However, the disclosure is not limited thereto.

The gate insulating layer GI, the interlayer insulating layer ILD, and the protective layer PSV may be interposed between each layer to electrically separate the active layer ACT, the gate electrode layer GE, the source/drain electrode layer SDL, and the alignment electrode layer ELT to each other. According to one or more embodiments, suitable electrode patterns may be electrically connected to each other through a contact hole (for example, a contact portion CNT) formed in any one of the gate insulating layer GI, the interlayer insulating layer ILD, and the protective layer PSV.

According to one or more embodiments, the gate insulating layer GI, the interlayer insulating layer ILD, and the protective layer PSV may include at least one of silicon nitride (SiNx), silicon oxide (SiOx), silicon oxynitride (SiOxNy), and aluminum oxide (AlOx). According to one or more embodiments, the gate insulating layer GI, the interlayer insulating layer ILD, and the protective layer PSV may include an organic material, and may be configured of a single layer or a plurality of layers.

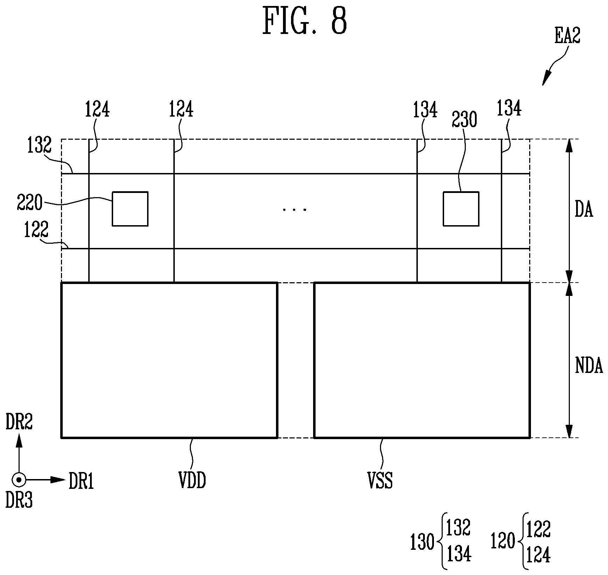

According to one or more embodiments, the alignment electrode layer ELT may be located in the display area DA, and may be omitted from the non-display area NDA. Details thereof are described later with reference to FIG. 8.

Hereinafter, electrode structures included in the display device 100 according to one or more embodiments are described in more detail with reference to FIGS. 7 to 14.

First, electrode lines provided in the display area DA and the non-display area NDA are described with reference to FIGS. 7 to 10.

FIG. 7 is an enlarged view of an area EA1 of FIG. 4. FIG. 7 is a plan view illustrating a portion of the fan-out area 300 according to one or more embodiments.

Referring to FIG. 7, the first power line VDD, the second power line VSS, and the fan-out line 320 may be located in the fan-out area 300.

According to one or more embodiments, the fan-out line 320 may be located on a layer that is different from that of the first power line VDD and the second power line VSS. For example, the fan-out line 320 may be located on the same layer as the barrier electrode layer BML. The fan-out line 320 may be formed in the same process as the barrier electrode layer BML. However, the disclosure is not limited thereto, and the fan-out line 320 may be located on a layer that is different from that of the barrier electrode layer BML according to one or more embodiments.

According to one or more embodiments, each of the first power line VDD and the second power line VSS may have a plate shape. For example, each of the first power line VDD and the second power line VSS may have a shape that flatly covers a corresponding area within the fan-out area 300.

According to one or more embodiments, the first power line VDD and the second power line VSS might not overlap in the fan-out area 300 when viewed in a plan view.

For example, the fan-out area 300 may include a first overlapping area 422, a second overlapping area 424, and a separation area 426. At this time, the first overlapping area 422 may mean an area where the first power line VDD and the fan-out line 320 overlap when viewed in a plan view. The second overlapping area 424 may mean an area where the second power line VSS and the fan-out line 320 overlap when viewed in a plan view. The separation area 426 may mean an area where the first power line VDD and the second power line VSS are not located.

According to one or more embodiments, the first power line VDD and the second power line VSS may be spaced apart from each other in a first direction DR1. The first power line VDD and the second power line VSS may be spaced apart from each other with the separation area 426 therebetween.

For example, the first power line VDD and the second power line VSS may be spaced apart from each other to define the separation area 426. Accordingly, a thickness direction (e.g., a width) of the separation area 426 may correspond to (or may be the same as) the first direction DR1, and a longitudinal direction (e.g., a length) of the separation area 426 may correspond to (or may be the same as) a second direction DR2 that is non-parallel to (or that intersects) the first direction DR1.

The first direction DR1 and the second direction DR2 defined herein are not limited to specific directions, respectively. For example, the first direction DR1 may be defined as a horizontal direction, and the second direction DR2 may be defined as a vertical direction. However, according to one or more embodiments, the first direction DR1 may refer to a specific direction, and the second direction DR2 may refer to a direction that is at least non-parallel to (or different from) the specific direction.

According to one or more embodiments, the fan-out line 320 may be located in the first overlapping area 422, the second overlapping area 424, and/or the separation area 426 when viewed in a plan view. Although the fan-out line 320 is arranged on the entire surface in FIG. 7, the fan-out line 320 may include a plurality of lines spaced apart from each other according to one or more embodiments. However, the disclosure is not limited thereto, and various disposition forms may be implemented to configure the fan-out area 300.

FIG. 8 is an enlarged view of an area EA2 of FIG. 4. FIG. 8 shows a connection relationship between the first power line VDD and the second power line VSS, as located in the non-display area NDA, and lines in the display area DA.

According to one or more embodiments, at least a portion of each of the first signal line 120 and the second signal line 130 may be located in the display area DA.

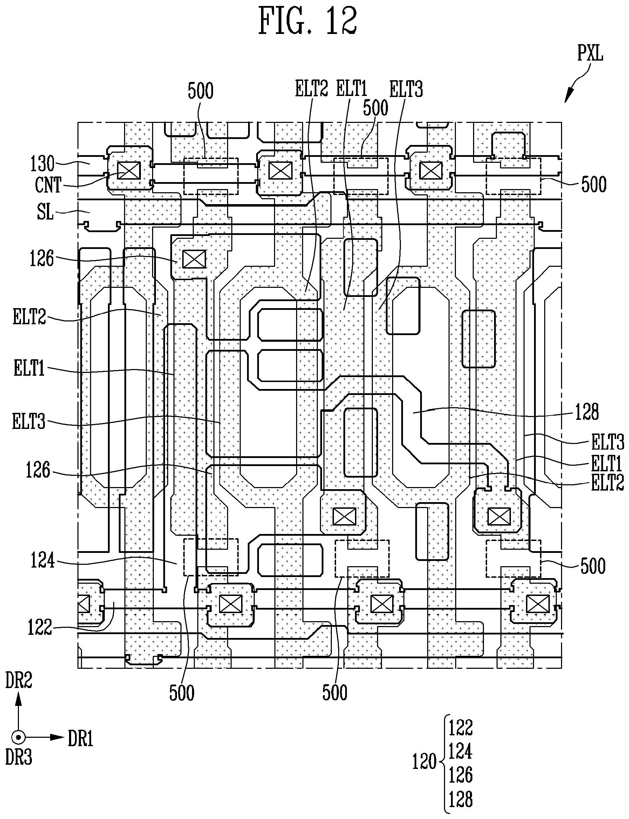

According to one or more embodiments, the first signal line 120 and the second signal line 130 may be located on a layer that is different from that of the alignment electrode layer ELT. For example, the first signal line 120 and the second signal line 130 may be located on a layer that is different from that of a first electrode (refer to reference character ELT1 of FIG. 12, which may be referred to as a first alignment electrode), and a second electrode (refer to reference character ELT2 of FIG. 12, which may be referred to as a second alignment electrode). A distance at which the first electrode ELT1 and the second electrode ELT2 are spaced apart from the substrate SUB may be greater than a distance at which the first signal line 120 and the second signal line 130 are spaced apart from the substrate SUB.

According to one or more embodiments, the first power line VDD and the second power line VSS might not be located in the display area DA. According to one or more embodiments, the first power line VDD and the second power line VSS having a plate shape may be separated into a plurality of lines, and the plurality of separated lines may be connected to each pixel PXL in the display area DA.

For example, the first power line VDD may be electrically connected to a line provided to the display area DA through a contact hole (e.g., predetermined contact hole), and an electrical signal provided from the first power line VDD may be applied to the light emitting element LD. The second power line VSS may be electrically connected to a line provided to the display area DA through a contact hole (e.g., predetermined contact hole), and an electrical signal provided from the second power line VSS may be applied to the light emitting element LD.

According to one or more embodiments, the first power line VDD and the second power line VSS may be located on a layer that is different from that of the alignment electrode layer ELT.

According to one or more embodiments, a line to which the first power is supplied through the first power line VDD may be located on a layer that is different from that of the alignment electrode layer ELT. A line to which the second power is supplied through the second power line VSS may be located on a layer that is different from that of the alignment electrode layer ELT.

According to one or more embodiments, the first power line VDD may be electrically connected to the first signal line(s) 120 in an area adjacent to the display area DA. At this time, the first signal line 120 may be located on a layer that is lower than that of the first power line VDD, or may be located on the same layer as the first power line VDD in an area electrically connected to the first power line VDD. For example, a distance at which the first signal line 120 is spaced apart from the substrate SUB may be less than a distance at which the first power line VDD and the second power line VSS are spaced apart from the substrate SUB. According to one or more embodiments, the first signal line 120 may be located on a layer that is different from that of the alignment electrode layer ELT in an area electrically connected to the first power line VDD.

According to one or more embodiments, the second power line VSS may be electrically connected to the second signal line 130 in an area adjacent to the display area DA. At this time, the second signal line 130 may be located on a layer that is lower than that of the second power line VSS or may be located on the same layer as the second power line VSS in an area electrically connected to the second power line VSS. For example, a distance at which the second signal line 130 is spaced apart from the substrate SUB may be less than a distance at which the first power line VDD and the second power line VSS are spaced apart from the substrate SUB. According to one or more embodiments, the second signal line 130 may be located on a layer that is different from that of the alignment electrode layer ELT in an area electrically connected to the second power line VSS.

According to one or more embodiments, the first power line VDD may be connected to the first signal line 120. The first power supplied to the first power line VDD may be applied to the light emitting element LD via the first signal line 120.

According to one or more embodiments, at least a portion of the first signal line 120 may extend in the first direction DR1, and at least another portion of the first signal line 120 may extend in the second direction DR2. For example, according to one or more embodiments, the first signal line 120 may include a (1-1)-th signal line 122 and a (1-2)-th signal line 124.

According to one or more embodiments, an extension direction of the (1-1)-th signal line 122 may be non-parallel to an extension direction of the (1-2)-th signal line 124. For example, the (1-1)-th signal line 122 may extend in the first direction DR1, and the (1-2)-th signal line 124 may extend in the second direction DR2 that is non-parallel to (and/or intersecting with) the first direction DR1.

According to one or more embodiments, a plurality of (1-2)-th signal lines 124 may be provided, and the (1-2)-th first signal lines 124 adjacent to each other may be spaced apart from each other in the first direction DR1.

According to one or more embodiments, the direction in which the (1-1)-th signal line 122 extends may be the same as the direction in which the first power line VDD and the second power line VSS are spaced apart from each other. For example, as described above, the first power line VDD and the second power line VSS may be spaced apart from each other in the first direction DR1, and the (1-1)-th signal line 122 may extend in the first direction DR1.

According to one or more embodiments, the direction in which the (1-2)-th signal line 124 extends is the same as a direction from an area in which the first power line VDD and the second power line VSS are located toward the display area DA. For example, as described above, a direction from the first power line VDD and the second power line VSS toward the adjacent display area DA may be the second direction DR2, and similarly, the (1-2)-th signal line 124 may extend in the second direction DR2.

According to one or more embodiments, the second power line VSS may be connected to the second signal line 130. The second power supplied to the second power line VSS may be applied to the light emitting element LD via the second signal line 130.

According to one or more embodiments, at least a portion of the second signal line 130 may extend in the first direction DR1, and at least another portion of the second signal line 130 may extend in the second direction DR2. For example, according to one or more embodiments, the second signal line 130 may include a (2-1)-th signal line 132 and a (2-2)-th signal line 134.

According to one or more embodiments, an extension direction of the (2-1)-th signal line 132 may be non-parallel to an extension direction of the (2-2)-th signal line 134. For example, the (2-1)-th signal line 132 may extend in the first direction DR1, and the (2-2)-th signal line 134 may extend in the second direction DR2 that is non-parallel to (and/or intersecting with) the first direction DR1.

According to one or more embodiments, a plurality of (2-2)-th signal lines 134 may be provided, and adjacent (2-2)-th signal lines 134 may be spaced apart from each other in the first direction DR1.

According to one or more embodiments, the direction in which the (2-1)-th signal line 132 extends may be the same as the direction in which the first power line VDD and the second power line VSS are spaced apart from each other. For example, as described above, the first power line VDD and the second power line VSS may be spaced apart from each other in the first direction DR1, and the (2-1)-th signal line 132 may extend in the first direction DR1.

According to one or more embodiments, the direction in which the (2-2)-th signal line 134 extends may be the same as a direction from the area in which the first power line VDD and the second power line VSS are located toward the display area DA. For example, as described above, the direction from the first power line VDD and the second power line VSS toward the adjacent display area DA may be the second direction DR2, and similarly, the (2-2)-th signal line may extend in the second direction DR2.

According to one or more embodiments, the first power line VDD located in the non-display area NDA may provide an electrical signal to the display area DA through a first electrode path (e.g., predetermined first electrode path). The second power line VSS located in the non-display area NDA may provide an electrical signal to the display area DA through a second electrode path (e.g., predetermined second electrode path).

According to one or more embodiments, the first signal line 120 and the second signal line 130 may be included in at least any one layer among the barrier electrode layer BML, the gate electrode layer GE, and the source/drain electrode layer SDL.

That is, according to one or more embodiments, the first signal line 120 and the second signal line 130 may include a single layer or a plurality of layers, and each of the first signal line 120 and the second signal line 130 may be formed (or provided) along a path (e.g., predetermined path).

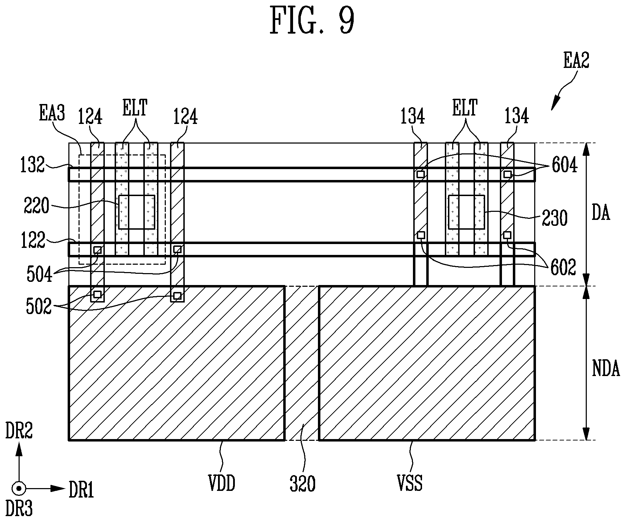

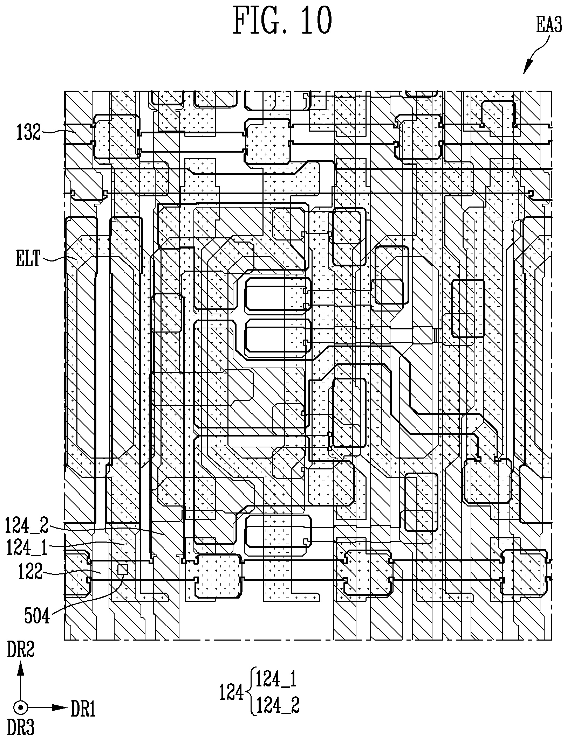

As one or more embodiments, referring to FIGS. 9 and 10, an implementation structure of the first signal line 120, the second signal line 130, the alignment electrode layer ELT, the first power line VDD, and the second power line VSS is described. FIG. 9 is an enlarged view of the area EA2 of FIG. 4, and is a plan view illustrating an electrode structure according to one or more embodiments. FIG. 10 is an enlarged view of an area EA3 of FIG. 9.

According to one or more embodiments, the alignment electrode layer ELT may be located in the display area DA, and might not be located in the non-display area NDA. That is, the first power line VDD and the second power line VSS may provide (or apply) an electrical signal through an electrode configuration (for example, the source/drain electrode layer SDL and the barrier electrode layer BML) that is not included in the alignment electrode layer ELT in the non-display area NDA.

According to one or more embodiments, the first power line VDD may include, or may be included in, the source/drain electrode layer SDL. The (1-1)-th signal line 122 may include, or may be included in, the source/drain electrode layer SDL. The (1-2)-th signal line 124 may include, or may be included in, the barrier electrode layer BML.

According to one or more embodiments, the first power line VDD may be electrically connected to the (1-2)-th signal line 124 extending in the second direction DR2 through a (1-1)-th contact member 502, and the (1-2)-th signal line 124 may be electrically connected to the (1-1)-th signal line 122 extending in the first direction DR1 through a (1-2)-th contact member 504. Accordingly, the first power line VDD and the (1-2)-th signal line 124 at least partially located on different layers may be electrically connected to each other through the (1-1)-th contact member 502, and an electrical signal provided from the first power line VDD may be moved along the second direction DR2 in the display area DA through the (1-2)-th signal line 124. In addition, the (1-2)-th signal line 124 and the (1-1)-th signal line 122 located on different layers may be electrically connected to each other through the (1-2)-th contact member 504, and the electrical signal provided from the first power line VDD may be moved along the first direction DR1 in the display area DA through the (1-1)-th signal line 122. Finally, the (1-1)-th signal line 122 and the (1-2)-th signal line 124 extending in different directions may be provided in a mesh structure, and may be configured to provide an electrical signal to individual pixels PXL.

According to one or more embodiments, the second power line VSS may include, or may be included in, the source/drain electrode layer SDL. The (2-1)-th signal line 132 may include, or may be included in, the source/drain electrode layer SDL. The (2-2)-th signal line 134 may include, or may be included in, the barrier electrode layer BML.

According to one or more embodiments, the second power line VSS may be electrically connected to the (2-2)-th signal line 134 extending in the second direction DR2 through a (2-1)-th contact member 602, and the (2-2)-th signal line 134 may be electrically connected to the (2-1)-th signal line 132 extending in the first direction DR1 through a (2-2)-th contact member 604. Accordingly, the second power line VSS and the (2-2)-th signal line 134 located on different layers may be electrically connected to each other through the (2-1)-th contact member 602, and an electrical signal provided from the second power line VSS may be moved along the second direction DR2 in the display area DA through the (2-2)-th signal line 134. In addition, the (2-2)-th signal line 134 and the (2-1)-th signal line 132 located on different layers may be electrically connected to each other through the (2-2)-th contact member 604, and the electrical signal provided from the second power line VSS may be moved along the first direction DR1 in the display area DA through the (2-1)-th signal line 132. Finally, the (2-1)-th signal line 132 and the (2-2)-th signal line 134 extending in different directions may be provided in a mesh structure, and may be configured to provide an electrical signal to individual pixels PXL.

Meanwhile, FIG. 10 shows a detailed electrode layout structure centered on the area EA3 of FIG. 9. For example, FIG. 10 shows a path through which the electrical signal provided from the first power line VDD is provided.

Referring to FIG. 10, the electrical signal provided from the first power line VDD may be ultimately provided to the alignment electrode layers ELT after being adjacent to, or passing by, the individual pixel PXL. Accordingly, the alignment electrode layers ELT might not be located in the non-display area DA. For example, the electrical signal provided from the first power line VDD may be move in the second direction DR2 through the (1-2)-th signal line 124, may be move in the first direction DR1 through the (1-1)-th signal line 122, and may be provided to any one of the alignment electrode layers ELT.

According to one or more embodiments, the (1-2)-th signal line 124 may include a first portion 124_1 corresponding to the barrier electrode layer BML and a second portion 124_2 corresponding to the source/drain electrode layer SDL.

According to one or more embodiments, the first portion 124_1 of the (1-2)-th signal line 124 may generally extend along the second direction DR2 in the display area DA such that the electrical signal provided from the first power line VDD may be provided to a line (for example, a column line) along the second direction DR2 in the display area DA. For example, a portion of the first portion 124_1 of the (1-2)-th signal line 124 may overlap a first pixel that is any one of the pixels PXL along the first direction DR1, and may provide the electrical signal through the (1-1)-th signal line 122 adjacent to the first pixel. In addition, the electrical signal may be provided through the (1-1)-th signal line 122 overlapping a second pixel, which overlaps the first pixel of the first portion 124_1 of the (1-2)-th signal line 124 along the second direction DR2, along the first direction and adjacent to the second pixel.

The first portion 124_1 of the (1-2)-th signal line 124 may be electrically connected to the (1-1)-th signal line 122 through the (1-2)-th contact member 504.

According to one or more embodiments, the second portion 124_2 of the (1-2)-th signal line 124 may generally extend along the second direction DR2 in the display area DA to allow the electrical signal provided from the first power line VDD to the individual pixel PXL. For example, the electrical signal provided from the first power line VDD may be provided to the first electrode ELT1 via the first signal line 122 and the second portion 124_2 of the (1-2)-th signal line 124.

According to one or more embodiments, the (2-1)-th signal line 132 may extend in the first direction DR1 and may be located adjacent to the pixel PXL.

A structure of the first signal line 120, the second signal line 130, the first power line VDD, and the second power line VSS are not necessarily limited to the above-described example. Hereinafter, for convenience of description, the disclosure is described based on one or more embodiments in which at least a portion of the first signal line 120 and the second signal line 130 includes, or is included in, the source/drain electrode layer SDL. In addition, the second signal line 124 is described based on the second portion 124_2 of the (1-2)-th signal line 124. However, the disclosure is not limited thereto, and a layer on which the first signal line 120 and the second signal line 130 are located may be appropriately selected. For example, lines configuring the first signal line 120 may be located on different layers, and lines configuring the second signal line 130 may be located on different layers.

According to one or more embodiments, the display area DA may include a first adjacent pixel area 220 and a second adjacent pixel area 230, as shown in FIGS. 8 and 9. The first adjacent pixel area 220 may mean an area in which any one of the pixels PXL located adjacent to the first power line VDD is located. The second adjacent pixel area 230 may mean an area in which any one of the pixels PXL located adjacent to the second power line VSS is located.

According to one or more embodiments, the first adjacent pixel area 220 may overlap the first power line VDD in the second direction DR2 (e.g., may be above the first power line VDD in plan view). The first adjacent pixel area 220 might not overlap the second power line VSS in the second direction DR2 (e.g., might not be above the second power line VSS in plan view). An overlap of the first adjacent pixel area 220 with the second power line VSS in the second direction DR2 may be avoided.

Conversely, the second adjacent pixel area 230 may overlap the second power line VSS in the second direction DR2, and the second adjacent pixel area 230 might not overlap the first power line VDD in the second direction DR2. An overlap of the second adjacent pixel area 230 with the first power line VDD in the second direction DR2 may be avoided.

According to one or more embodiments, the first adjacent pixel area 220 and the second adjacent pixel area 230 may overlap along the first direction DR1.

According to one or more embodiments, the light emitting element LD located in the first adjacent pixel area 220 may receive the first power from the first signal line 120, and may receive the second power from the second signal line 130. The light emitting element LD located in the second adjacent pixel area 230 may receive the first power from the first signal line 120, and may receive the second power from the second signal line 130.

For example, the first power provided from the first power line VDD may be applied to the light emitting element LD via the first signal line 120 and the first electrode ELT1. The second power provided from the second power line VSS may be applied to the light emitting element LD via the second signal line 130 and the second electrode ELT2.

According to one or more embodiments, the light emitting element LD located in the first adjacent pixel area 220 may receive the second power from the second power line VSS. At this time, experimentally, because the first adjacent pixel area 220 does not overlap the second power line VSS in the second direction DR2, the light emitting element LD located in the first adjacent pixel area 220 may be difficult to receive power directly from a line extending in the second direction DR2. However, according to one or more embodiments, the second signal line 130 functioning as a path through which the second power is provided may include the (2-1)-th signal line 132 and the (2-2)-th signal line 134, which are non-parallel to each other, and thus the second power provided from the second power line VSS may be applied to the light emitting element LD in the first adjacent pixel area 220.

According to one or more embodiments, the light emitting element LD located in the second adjacent pixel area 230 may receive the first power from the first power line VDD. Experimentally, because the second adjacent pixel area 230 does not overlap the first power line VDD in the second direction DR2, the light emitting element LD located in the second adjacent pixel area 230 may be difficult to receive power directly from a line extending in the second direction DR2. However, according to one or more embodiments, the first signal line 120 functioning as a path through which the first power is provided may include the (1-1)-th signal line 122 and the (1-2)-th signal line 124, which are non-parallel to each other, and thus the first power provided from the first power line VDD may be applied to the light emitting element LD in the second adjacent pixel area 230.

Accordingly, the first signal line 120 and the second signal line 130 in the display area DA may be configured of a plurality of lines crossing each other, and thus a mesh pattern defined by the first signal line 120 and the second signal line 130 may be formed in the display area DA.

According to one or more embodiments, the alignment electrode layer ELT might not be located in an area where the first power line VDD and the second power line VSS are located. Experimentally, the alignment electrode layer ELT is a layer formed on the same layer as the first electrode ELT1 functioning as the first alignment electrode and the second electrode ELT2 functioning as the second alignment electrode, and may suitably have a thin thickness so that the light emitting element LD is located between the first electrode ELT1 and the second electrode ELT2. Accordingly, when the alignment electrode layer ELT is electrically connected to the first power line VDD and/or the second power line VSS, a risk that heat is to be generated in a connected area exists.

However, according to one or more embodiments, a structure in which the alignment electrode layer ELT is not necessarily required in an area where the first power line VDD and the second power line VSS are electrically connected thereto (e.g., as an area where the first power line VDD and the second power line VSS are located and/or an area where the first power line VDD and the second power line VSS are adjacent). That is, according to an example, an electrode configuration formed in the same process as that of the first electrode ELT1 and the second electrode ELT2 may not be located in the non-display area NDA. Furthermore, electrode lines connected to the first power line VDD and the second power line VSS may be implemented to be included in any one of the barrier electrode layer BML, the gate electrode layer GE, and the source/drain electrode layer SDL rather than the alignment electrode layer ELT. At this time, according to one or more embodiments, a thickness of each of the barrier electrode layer BML, the gate electrode layer GE, and the source/drain electrode layer SDL may be greater than a thickness of the alignment electrode layer ELT. Accordingly, when the electrode line for the first power line VDD and the second power line VSS is connected, a risk associated with heat generation may be reduced. According to one or more embodiments, a thickness of the first electrode ELT1 and a thickness of the second electrode ELT2 may be greater than a thickness of the first signal line 120 and a thickness of the second signal line 130.

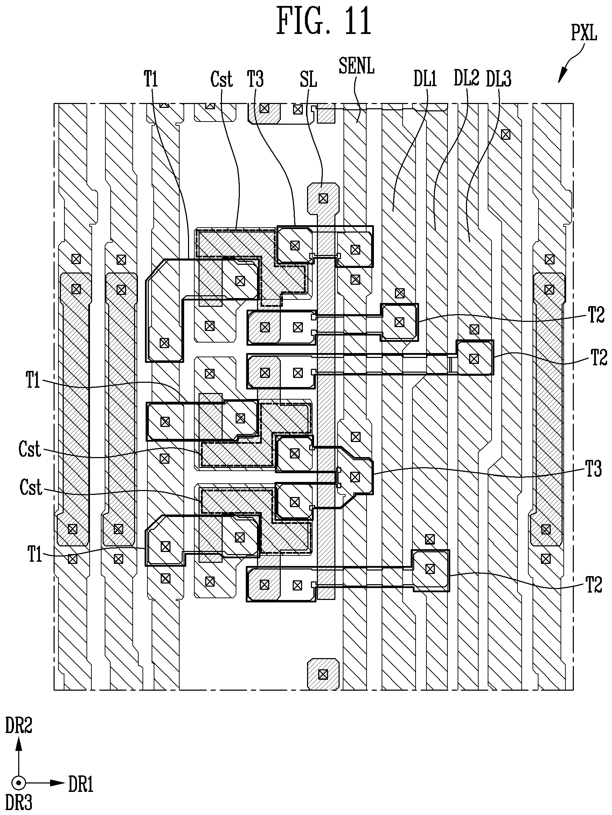

Hereinafter, the display device 100 according to one or more embodiments is described with reference to FIGS. 11 to 14 based on an electrode line included in the display area DA.

FIGS. 11 and 12 are layout diagrams illustrating electrode configurations configuring a pixel according to one or more embodiments.

FIGS. 11 and 12 show electrode configurations of the pixel PXL. FIGS. 11 and 12 show different layers with respect to the same area. FIG. 11 shows the barrier electrode layer BML, the active layer ACT, and the gate electrode layer GE described above with reference to FIG. 6. FIG. 12 shows the source/drain electrode layer SDL and the alignment electrode layer ELT described above with reference to FIG. 6. In FIG. 12, the source/drain electrode layer SDL is indicated by a thick solid line border, and contact holes for electrically connecting different electrode patterns are indicated by an X in a quadrangle box.

According to one or more embodiments, the first to third transistors T1 to T3, the storage capacitor Cst, first to third data lines DL1 to DL3, the scan line SL, and the sensing line SENL may be included and located in the pixel PXL.

As described above with reference to FIG. 5, the first to third transistors T1 to T3 and the storage capacitor Cst may configure one pixel circuit PXC. FIG. 11 shows a structure in which the first to third transistors T1 to T3 and the storage capacitor Cst configure each of three different pixel circuits PXC.

Referring to FIG. 12, the first signal line 120, the second signal line 130, and first to third electrodes ELT1 to ELT3 may be included and located in the pixel PXL.

According to one or more embodiments, as described above, the first signal line 120 may include the (1-1)-th signal line 122 and the (1-2)-th signal line 124. According to one or more embodiments, the first signal line 120 may further include a (1-3)-th signal line 126 and a (1-4)-th signal line 128.

According to one or more embodiments, the first power provided from the first power line VDD may be provided to the first electrode (ELT1, which may be referred to as the first alignment electrode) via the (1-1)-th signal line 122, the (1-2)-th signal line 124, and the (1-3)-th signal line 126. The (1-3)-th signal line 126 may be electrically connected to the first electrode ELT1 through the contact portion CNT formed in the protective layer PSV. The first power provided to the first electrode ELT1 may be provided to the light emitting element LD.

According to one or more embodiments, the first power provided from the first power line VDD may be provided to the first electrode ELT1 via the (1-1)-th signal line 122, the (1-2)-th signal line 124, and the (1-4)-th signal line 128. The (1-4)-th signal line 128 may be electrically connected to the first electrode ELT1 through the contact portion. The first power provided to the first electrode ELT1 may be provided to the light emitting element LD.

According to one or more embodiments, the second signal line 130 may be electrically connected to the second electrode ELT2 and/or the third electrode ELT3 through the contact portion CNT. Accordingly, the second power provided from the second power line VSS may be provided to the second electrode ELT2 and/or the third electrode ELT3 via the second signal line 130. The second power provided to the second electrode ELT2 and/or the third electrode ELT3 may be provided to the light emitting element LD.

According to one or more embodiments, the light emitting element LD may be located on the first electrode ELT1 and the second electrode ELT2. The light emitting element LD may be located on the first electrode ELT1 and the third electrode ELT3.

According to one or more embodiments, the light emitting element LD may be located between the first electrode ELT1 and the second electrode ELT2. The light emitting element LD may be located between the first electrode ELT1 and the third electrode ELT3. At least a portion of the light emitting element LD may be positioned between the first electrode ELT1 and the second electrode ELT2 and/or between the first electrode ELT1 and the third electrode ELT3.

According to one or more embodiments, a potential defined by the second power supplied from the second power line VSS is formed in the second electrode ELT2 and the third electrode ELT3, and a potential defined by the first power provided from the first power line VDD is formed in the first electrode ELT1. Accordingly, an electric field for arranging the light emitting elements LD may be formed between the first electrode ELT1 and the second electrode ELT2, and thus, a lane area may be provided. In addition, an electric field for arranging the light emitting elements LD may be formed between the first electrode ELT1 and the third electrode ELT3, and thus a lane area may be provided.

The lane area may be an area where the light emitting element LD is to be located, and when viewed in a plan view, the lane area may overlap at least a portion of the light emitting element LD, and each of electrodes may be spaced apart from each other by the lane area. For example, the first electrode ELT1 and the second electrode ELT2 may be spaced apart from each other along the first direction DR1, and the light emitting element LD may be located in the lane area defined accordingly. Similarly, the second electrode ELT2 and the third electrode ELT3 may be spaced apart from each other along the first direction DR1, and the light emitting element LD may be located in the lane area defined accordingly.

According to one or more embodiments, a cut area 500 may be formed in an area adjacent to the first electrode ELT1. The cut area 500 may be formed on and/or under the first electrode ELT1.

According to one or more embodiments, the cut area 500 may be an area in which a portion of an electrode layer (e.g., predetermined electrode layer) is removed after forming the electrode layer (e.g., predetermined electrode layer), and may be an area provided to separate the first electrodes ELT1 adjacent to each other in the second direction DR2. According to one or more embodiments, after the electrode layer (e.g., predetermined electrode layer) is formed and an insulating layer is formed on the electrode layer (e.g., predetermined electrode layer), the insulating layer located at a position where the cut area 500 is to be formed may be removed. In addition, the electrode layer (e.g., predetermined electrode layer) may be etched in an area from which at least a portion of the insulating layer is removed to form the cut area 500.

According to one or more embodiments, after the cut area 500 is formed and the light emitting element LD is arranged, the first power may be supplied to the first electrode ELT1. Accordingly, the first electrode ELT1 may be prevented from being provided as a floating line, and crosstalk of an electrical signal may be reduced or prevented.

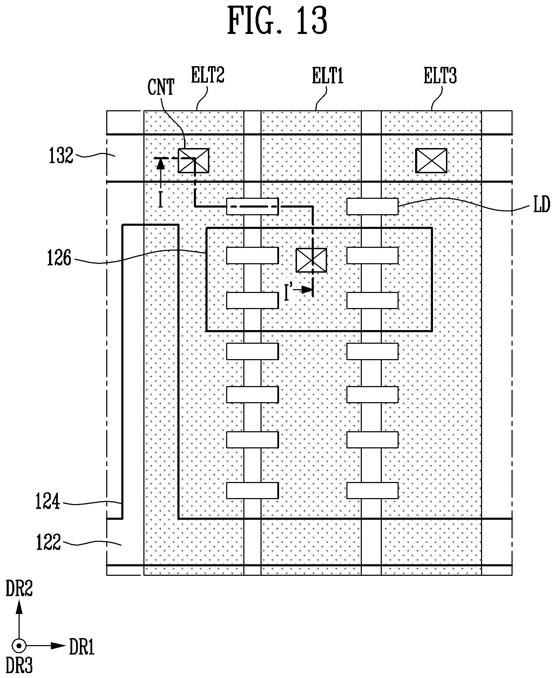

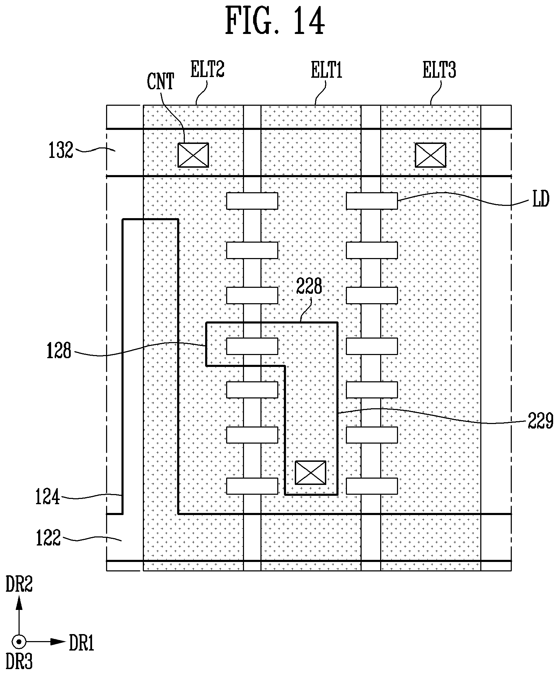

Subsequently, a structure of the first signal line 120 and the second signal line 130 according to one or more embodiments is described with reference to FIGS. 13 and 14.

FIGS. 13 and 14 are plan views schematically illustrating an electrode line according to one or more embodiments.

FIG. 13 is a diagram shown centered on the (1-3)-th signal line 126 of the first signal line 120. FIG. 14 is a diagram shown centered on the (1-4)-th signal line 128 of the first signal line 120.

According to one or more embodiments, the first to third electrodes ELT1 to ELT3 may be arranged. The respective light emitting elements LD may be located between the first electrode ELT1 and the second electrode ELT2, and may be located between the first electrode ELT1 and the third electrode ELT3.

According to one or more embodiments, the (1-2)-th signal line 124 may be connected to the (1-1)-th signal line 122. The (1-2)-th signal line 124 may have a shape branded from the (1-1)-th signal line 122. For example, the (1-1)-th signal line 122 may extend in the first direction DR1, and may be configured as a body line, and the (1-2)-th signal line 124 may extend in the second direction DR2 and may be configured as a branch line protruding from the (1-1)-th signal line 122 configured as the body line. Accordingly, the first power provided along the (1-1)-th signal line 122 may be moved to the (1-2)-th signal line 124.

According to one or more embodiments, the (1-3)-th signal line 126 and/or the (1-4)-th signal line 128 may be located between the (1-1)-th signal line 122 and the (2-1)-th signal line 132 extending in the first direction DR1.

According to one or more embodiments, the (1-3)-th signal line 126 may be electrically connected to the (1-2)-th signal line 124 (refer to FIG. 13). For example, the (1-3)-th signal line 126 may be formed in an island shape and may be electrically connected to the (1-2)-th signal line 124. In one or more embodiments, the (1-2)-th signal line 124 and the (1-3)-th signal line 126 may be connected to electrode configurations, which may be provided on another layer (for example, the barrier electrode layer BML), through a contact hole, respectively, and finally, the (1-2)-th signal line 124 and the (1-3)-th signal line 126 may be electrically connected to each other. However, the disclosure is not limited thereto, and the (1-2)-th signal line 124 and the (1-3)-th signal line 126 may be physically connected to each other according to one or more embodiments.

According to one or more embodiments, at least a portion of the (1-3)-th signal line 126 may extend in the same direction as the (1-1)-th signal line 122. The (1-3)-th signal line 126 may extend in the first direction DR1. At least a portion of the (1-3)-th signal line 126 may extend in a direction crossing the direction in which the (1-2)-th signal line 124 extends. Accordingly, the first power provided from the first power line VDD may be applied to the alignment electrode (for example, the first electrode ELT1) to be provided along the (1-3)-th signal line 126.

According to one or more embodiments, the (1-4)-th signal line 128 may be electrically connected to the (1-2)-th signal line 124 (refer to FIG. 14). For example, the (1-4)-th signal line 128 may be connected to an electrode configuration, which is provided on another layer (for example, the barrier electrode layer BML), through a contact hole, the (1-2)-th signal line 124 may be connected to the electrode configuration provided in the other layer through a contact hole, and thus the (1 -2)-th signal line 124 and the (1-4)-th signal line 128 may be electrically connected to each other. However, the disclosure is not limited thereto, and the (1-4)-th signal line 128 and the (1-3)-th signal line 126 may be physically connected to each other according to one or more embodiments.

According to one or more embodiments, the (1-4)-th signal line 128 may include a first extension portion 228 extending in the first direction DR1 and a second extension portion 229 extending in the second direction DR2. According to one or more embodiments, a length (and/or a thickness) of the first extension portion 228 and a length (and/or a thickness) of the second extension portion 229 of the (1-4)-th signal line 128 may be appropriately selected, and thus, the first power provided from the first power line VDD may be provided up to the alignment electrode (for example, the first electrode ELT1).

However, the structure of the first signal line 120 and the second signal line 130 is not limited to the above-described example. For example, the second signal line 130 may include signal lines implemented in a structure that is similar to that of the (1-3)-th signal line 126 and the (1-4)-th signal line 128 included in the first signal line 120.

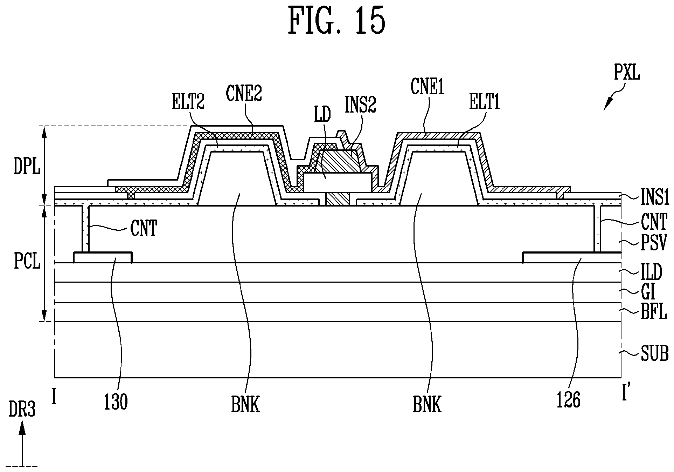

Hereinafter, a cross-sectional structure of the pixel PXL according to one or more embodiments is described with reference to FIG. 15.

FIG. 15 is a cross-sectional view taken along a line I ~ I' of FIG. 13. FIG. 15 is a diagram illustrating a stack structure including the light emitting element LD. Contents that may be repetitive to those described above are simplified or omitted.

Referring to FIG. 15, the pixel PXL may include the substrate SUB, a pixel circuit unit PCL, and a display element unit DPL.

The pixel circuit unit PCL may include the buffer layer BFL, the gate insulating layer GI, the interlayer insulating layer ILD, the (1-3)-th signal line 126, the second signal line 130, and the protective layer PSV.

According to one or more embodiments, the (1-3)-th signal line 126 may be located on the interlayer insulating layer ILD. The (1-3)-th signal line 126 may be electrically connected to the first electrode ELT1 through the contact portion CNT formed in the protective layer PSV.

According to one or more embodiments, the second signal line 130 may be located on the interlayer insulating layer ILD. The second signal line 130 may be electrically connected to the second electrode ELT2 through the contact portion CNT formed in the protective layer PSV.

Meanwhile, in some embodiments, the pixel circuit unit PCL may include at least any one of the first to third transistors T1 to T3. For example, the pixel circuit unit PCL may include the first transistor T1, and the light emitting element LD may emit light based on an electrical signal provided from the first transistor T1.

According to one or more embodiments, the first transistor T1 may include a source electrode and a drain electrode. According to an example, the source electrode and the drain electrode may be located on the same layer as the first signal line 120 and the second signal line 130.

The display element unit DPL may include a bank BNK, the first electrode ELT1, and the second electrode ELT2 included in the alignment electrode layer ELT, a first insulating layer INS1, a first contact electrode CNE1, the light emitting element LD, a second contact electrode CNE2, and a second insulating layer INS2.

According to one or more embodiments, the bank BNK may have a shape protruding in an upper direction. The upper direction may be a display direction of the light emitting element LD and may mean a third direction DR3. The first electrode ELT1 and the second electrode ELT2 may be located on the bank BNK, a reflective partition wall may be formed with respect thereto, and thus light efficiency of the light emitting element LD may be improved.

According to one or more embodiments, the first electrode ELT1 may be electrically connected to the (1-3)-th signal line 126 through the contact portion CNT. Accordingly, the power supplied from the first power line VDD may be provided to the first electrode ELT1 through the (1-3)-th signal line 126.

According to one or more embodiments, the second electrode ELT2 may be electrically connected to the second signal line 130 through the contact portion CNT. Accordingly, the power supplied from the second power line VSS may be provided to the second electrode ELT2 through the second signal line 130.

According to one or more embodiments, a distance at which the first electrode ELT1 and the second electrode ELT2 are spaced apart from the substrate SUB may be greater than a distance at which the first signal line 120 and the second signal line 130 are spaced apart from the substrate SUB.

The first insulating layer INS1 may be located on the protective layer PSV. The first insulating layer INS1 may include at least one of silicon nitride (SiNx), silicon oxide (SiOx), silicon oxynitride (SiOxNy), and aluminum oxide (AlOx). The first insulating layer INS1 may stabilize an electrical connection between electrode configurations, and may attenuate an external influence.

The light emitting element LD may be positioned on the first insulating layer INS1. According to an example, the first insulating layer INS1 may have a groove (e.g., predetermined groove), at least a portion of the light emitting element LD may be in contact with an end formed from the groove, and another portion of the light emitting element LD may be in contact with another end formed from the groove.

The second insulating layer INS2 may be located on the light emitting element LD. The second insulating layer INS2 may be formed to cover an area corresponding to the active layer 12 of the light emitting element LD. According to one or more embodiments, the second insulating layer INS2 may include any one of an organic material or an inorganic material. According to one or more embodiments, the second insulating layer INS2 may fill a space provided on a rear surface of the light emitting element LD.

The first contact electrode CNE1 and the second contact electrode CNE2 may be located on the first insulating layer INS1. The first contact electrode CNE1 and the second contact electrode CNE2 may be electrically connected to the first electrode ELT1 and the second electrode ELT2 through contact holes formed in the first insulating layer INS1, respectively.

According to one or more embodiments, the first contact electrode CNE1 and the second contact electrode CNE2 may include a transparent conductive material. According to an example, the first contact electrode CNE1 may include at least one of a conductive material including indium tin oxide (ITO), indium zinc oxide (IZO), and indium tin zinc oxide (ITZO).

A disposition relationship regarding the light emitting element LD, the electrode configuration, and the like is not limited to the example described above with reference to FIG. 15, and the disposition relationships according to various deformable embodiments may be implemented.

The above description is merely an example of the technical aspects of the present disclosure, and those skilled in the art to which the present disclosure pertains will be able to make various modifications and variations without departing from the essential characteristics of the present disclosure. Therefore, the embodiments of the present disclosure described above may be implemented separately or in combination with each other.

Therefore, the embodiments disclosed in the present disclosure are not intended to limit the technical aspects of the present disclosure, but to describe the technical aspects of the present disclosure, and the scope of the technical aspects of the present disclosure is not limited by these embodiments. The protection scope of the present disclosure should be interpreted by the following claims, and it should be interpreted that all technical aspects within the equivalent scope are included in the scope of the present disclosure.

## Claims

1. A display device comprising:
a first electrode (ELT1) and a second electrode (ELT2) on a substrate (SUB);
a pixel unit (102) comprising a light emitting element (LD) on the first electrode and the second electrode;
a first signal line (120) electrically connected to the first electrode (ELT1); and
a second signal line (130) electrically connected to the second electrode (ELT2),
wherein first power is configured to be provided to the first electrode (ELT1) from the first signal line (120),
wherein second power is configured to be provided to the second electrode (ELT2) from the second signal line (130),
wherein at least a portion of the first signal line (120) and at least a portion of the second signal line (130) extend in a first direction, and
wherein at least another portion of the first signal line (120) extends in a second direction that is not parallel to the first direction.

2. The display device according to claim 1, further comprising:
a display area in which the pixel unit is located;
a non-display area surrounding at least a portion of the display area;
a first power line having at least a portion in the non-display area, and configured to supply the first power to the first signal line; and
a second power line having at least a portion in the non-display area, and configured to supply the second power to the second signal line,
wherein the first power line and the second power line have a plate shape.

3. The display device according to claim 2, wherein the first power line and the second power line are spaced apart from each other in the first direction, and are on a same layer.

4. The display device according to claim 2 or 3, wherein the first power line and the second power line are on a layer that is different from that of the first electrode and the second electrode.

5. The display device according to claim 2, 3 or 4, wherein the first signal line comprises a (1-1)-th signal line extending in the first direction, and a (1-2)-th signal line extending in the second direction, and
wherein the second signal line comprises a (2-1)-th signal line extending in the first direction, and a (2-2)-th signal line extending in the second direction.

6. The display device according to claim 5, wherein the pixel unit comprises a first adjacent pixel area above the first power line in a plan view with respect to the second direction, and a second adjacent pixel area above the second power line in a plan view with respect to the second direction,
wherein the first adjacent pixel area is not above the second power line with respect to the second direction, and
the second adjacent pixel area is not above the second power line with respect to the second direction.

7. The display device according to claim 5 or 6, wherein the (1-1)-th signal line and the (2-1)-th signal line extend in a same direction in which the first power line and the second power line are spaced apart from each other.
and/or wherein the first power line is electrically connected to the first electrode through the (1-1)-th signal line and the (1-2)-th signal line, and
wherein the second power line is electrically connected to the second electrode through the (2-1)-th signal line and the (2-2)-th signal line.

8. The display device according to any one of claims 5 to 7, wherein the first signal line further comprises a (1-3)-th signal line electrically connected to the (1-2)-th signal line, and extending in a same direction as the (1-1)-th signal line, and
wherein the first power line is electrically connected to the first electrode through the (1-1)-th signal line, the (1-2)-th signal line, and the (1-3)-th signal line.

9. The display device according to any one of claims 5 to 8, wherein the first signal line further comprises a (1-4)-th signal line comprising a first extension portion electrically connected to the (1-2)-th signal line, and extending in a same direction as the (1-1)-th signal line, and a second extension portion extending in a same direction as the (1-2)-th signal line, and
wherein the first power line is electrically connected to the first electrode through the (1-1)-th signal line, the (1-2)-th signal line, and the (1-4)-th signal line.

10. The display device according to any preceding claim, further comprising a third electrode on the substrate, and configured to be provided with the second power supplied from the second signal line,
wherein the second electrode is on one side of the first electrode, and
wherein the third electrode is on another side of the first electrode.

11. The display device according to any preceding claim, further comprising a transistor electrically connected to the light emitting element, and comprising a source electrode and a drain electrode,
wherein the first signal line and the second signal line are on a same layer as the source electrode and the drain electrode.

12. The display device according to any preceding claim, wherein the first signal line and the second signal line are on a layer that is different from that of the first electrode and the second electrode.
and/or wherein at least a portion of the first signal line is on a layer that is different from that of at least a portion of the second signal line.
and/or wherein a distance at which the first electrode and the second electrode are spaced apart from the substrate is greater than a distance at which the first signal line and the second signal line are spaced apart from the substrate.

13. The display device according to any preceding claim, wherein a thickness of the first electrode and a thickness of the second electrode are greater than a thickness of the first signal line and a thickness of the second signal line.

14. The display device according to any preceding claim when also dependent directly or indirectly on claim 2,
wherein an electrode configuration formed in a same process as that of the first electrode and the second electrode is not in the non-display area;
and/or wherein the first signal line and the second signal line are on a same layer as the first power line and the second power line.
and/or wherein a distance at which the first signal line and the second signal line are spaced apart from the substrate is less than a distance at which the first power line and the second power line are spaced apart from the substrate.

15. A display device comprising:
a display area and a non-display area;
a first alignment electrode and a second alignment electrode on the display area;
a pixel unit comprising a light emitting element having at least a portion positioned between the first alignment electrode and the second alignment electrode;
a driving controller in the non-display area and configured to control driving of the pixel unit; and
a line unit comprising a first signal line electrically connected to the first alignment electrode, and a second signal line electrically connected to the second alignment electrode,
wherein the non-display area comprises a fan-out area positioned between the display area and the driving controller,
wherein the line unit comprises a first power line and a second power line having at least a portion in the fan-out area, and spaced apart from each other in a first direction, the first power line being configured to supply first power to the light emitting element through the first signal line and the first alignment electrode,
wherein the second power line is configured to supply second power different from the first power to the light emitting element through the second signal line and the second alignment electrode, and
wherein at least a portion of each of the first signal line and the second signal line extends in the first direction.
